Europäisches Patentamt

European Patent Office

Office européen des brevets

(11) Veröffentlichungsnummer: **0 022 960**
**B1**

(12) # EUROPÄISCHE PATENTSCHRIFT

(45) Veröffentlichungstag der Patentschrift:
21.09.83

(51) Int. Cl.³: **H 01 L 21/304, H 01 L 21/322**

(21) Anmeldenummer: **80103784.7**

(22) Anmeldetag: **03.07.80**

(54) **Verfahren zur stapelfehlerinduzierenden Oberflächenzerstörung von Halbleiterscheiben.**

(30) Priorität: **05.07.79 DE 2927220**

(43) Veröffentlichungstag der Anmeldung:
**28.01.81 Patentblatt 81/4**

(45) Bekanntmachung des Hinweises auf die Patenterteilung:
**21.09.83 Patentblatt 83/38**

(84) Benannte Vertragsstaaten:
**DE FR GB NL**

(56) Entgegenhaltungen:
**EP-A-0 002 205**
**CH-A-311 394**
**DE-A-1 096 502**
**DE-A-2 059 260**
**NL-B-134 092**
**US-A-3 385 682**

(73) Patentinhaber: **Wacker-Chemitronic Gesellschaft für Elektronik-Grundstoffe mbH,**
**Johannes-Hess-Strasse 24, D-8263 Burghausen (DE)**

(72) Erfinder: **Lampert, Ingolf, Kettelerstrasse 21,**
**D-8263 Burghausen (DE)**
Erfinder: **Wahllch, Reinhold, Gluckstrasse 3,**
**D-8263 Burghausen (DE)**

ACTORUM AG

## Verfahren zur stapelfehlderinduzierenden Oberflächenzerstörung von Halbleiterscheiben

Gegenstand der Erfindung ist ein Verfahren zur Herstellung von Halbleiterscheiben mit einer Oberfläche, in der sich bei nachfolgender Oxidationsbehandlung Stapelfehler mit Punktfehler getternder Wirkung ausbilden.

Bei der Herstellung elektronischer Bauelemente führen Punktdefekte zu erhöhten Ausbeuteverlusten, z.B. bei bipolaren Bauelementen durch höhere Leckströme, bei MOS-Bauelementen durch Verkürzung der refresh-time.

Aus der US-PS 4 042 419 ist es beispielsweise bekannt, Halbleiterscheiben, wie sie für die Herstellung derartiger Bauelemente verwendet werden, einseitig mit einem mechanischen Spannungsfeld zu versehen und nachfolgend einer Wärmebehandlung zu unterziehen. Das mechanische Spannungsfeld wird dabei durch Übersättigen des Kristallgitters im Oberflächenbereich der Halbleiterscheibe mit Fremdatomen mit gegenüber den Gitteratomen der Halbleiterscheibe unterschiedlicher Grösse erzeugt oder durch eine definierte Oberflächenzerstörung durch beispielsweise kurzzeitiges Schleifen mit einem geeigneten Läppmittel.

In der nachfolgenden Temperaturbehandlung, beispielsweise im Falle von Siliciumscheiben durch Tempern bei 800 bis 1200°C lassen sich dann die Punktdefekte absaugen. Die bei der hohen Temperatur beweglichen Punktdefekte in der Form von insbesondere Leerstellen oder Zwischengitteratomen werden nämlich durch das einseitig wirkende Spannungsfeld, bedingt durch die einseitige Oberflächenzerstörung oder durch das aufgrund von Fremddotierung ausgebildete, einseitige Vernetzungswerk aus der Halbleiterscheibe abgesaugt.

Die getternde, einseitige Oberflächenzerstörung lässt sich auch durch Sandstrahlblasen einer Scheibenseite oder durch geordnetes, gleichmässiges Verkratzen einer Scheibenseite, beispielsweise mit einem Griffel aus gegenüber dem Halbleitermaterial härterem Stoff, erzielen (vgl. US-PS 3 905 162).

Nachteilig bei den genannten Verfahren wirkt sich aber die Tatsache aus, dass die Scheibenrückseite häufig derartig massive Zerstörungen aufweist – in der US-PS 3 905 162 beispielsweise Kratzer von 5 µm Tiefe – dass diese bei den nachfolgenden Prozessen auf die Vorderseite durchschlagen können, ausserdem wird bei mehrfachen Oxidationsschritten die zerstörte Rückseitenschicht durch Oxydation verbraucht, so dass sie nach einiger Zeit ihre getternde Wirkung verliert.

Der Erfindung lag daher die Aufgabe zugrunde, eine Präparation von Halbleiterscheiben zu finden, durch welche sich auch bei mehrfachen Oxydationsprozessen Punktdefekte und Punktdefektagglomerate nachhaltig gettern lassen.

Gelöst wird diese Aufgabe durch ein Verfahren gemäss dem kennzeichnenden Teil des Patentanspruchs.

Als Schleifkörner eignen sich allgemein Substanzen mit gleicher oder grösserer Härte als die zu behandelnde Halbleiterscheibe also beispielsweise für Siliciumscheiben solche aus Silicium, Siliciumcarbid, Diamant, Zirkondioxid, Aluminiumoxid oder vorzugsweise Quarz.

Quarz wird deshalb für Siliciumscheiben bevorzugt eingesetzt, da sich nach dem Eintauchen an der Scheibe eventuell noch anhaftende Körner in dem nachfolgenden Reinigungsprozess rückstandslos in Flusssäure lösen und somit nicht in die Poliermaschine verschleppt werden können.

Die Korngrösse wird allgemein zweckmässig innerhalb 50 bis 1000 µm, vorzugsweise innerhalb 100 bis 400 µm gewählt.

Anhand der Abbildungen wird die Erfindung nachstehend näher erläutert:

Fig. 1 zeigt schematisch ein Gasfeststoffbad mit den eingetauchten Halbleiterscheiben.

Fig. 2–6 zeigen die nach der Oxydation durch die Mikrokratzer induzierten getternden Stapelfehler in Abhängigkeit von der Verweilzeit der Scheiben im Gasfeststoffbad.

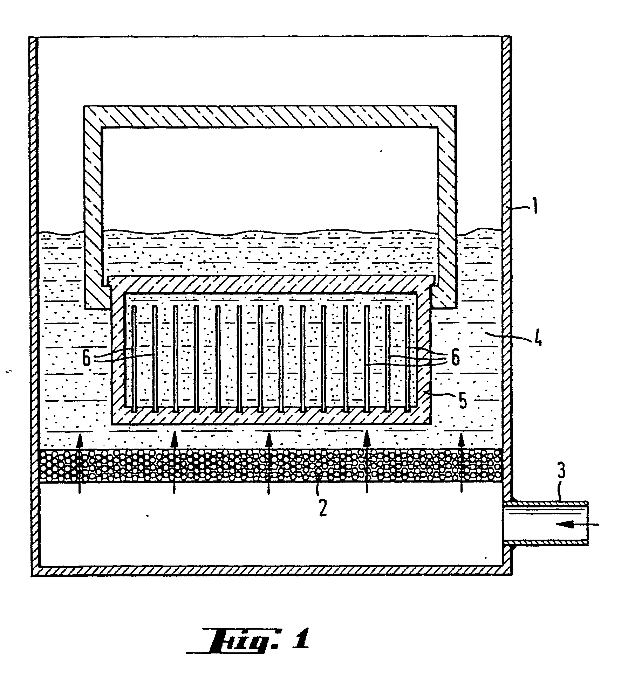

Das Bad besteht wie Fig. 1 zeigt – im Prinzip aus einem oben offenen Kasten 1 aus beispielsweise Aluminium, Stahl oder auch Kunststoff, in welchem unten ein zweiter, gasdurchlässiger Boden 2, beispielsweise eine feinporige Filterplatte oder eine Glas- oder Quarzfritte, eingezogen ist, durch welchen ein Gas, beispielsweise Pressluft, welches durch die Zuführung 3 in den Kasten 1 eingeleitet wird, strömt und eine oberhalb des gasdurchlässigen Bodens 2 aufliegende Schüttung aus Feststoffpartikelchen 4 aufwirbelt. Die einzelnen Feststoffpartikeln schweben, mikroskopisch durch das durchströmende Gas voneinander getrennt. Dieser Zustand, der auch als «Fluidisation» bezeichnet wird, verleiht dem Gasfeststoffbad die Eigenschaften einer Flüssigkeit. Zum Beispiel kann das fluidisierte Feststoffbad bewegt werden und es wirft Blasen, es sucht sich immer sein eigenes Niveau. Teile mit geringerem spezifischen Gewicht als dem des Bades schwimmen auf und schwerere versinken in ihm. In dieses Feststoffbad 4 wird anschliessend die Prozesshorde 5, in welcher die geläppten Halbleiterscheiben 6 bereits das Ätzbad und die anschliessende Trocknung passiert haben, direkt eingetaucht.

Die Verweilzeit beträgt etwa 10 bis 300 sec und ist im wesentlichen abhängig von der Korngrösse der Badschüttung sowie der Turbulenz also dem pro Rauminhalt eingestellten Gasdurchsatz.

Der Gasdurchsatz selbst ist ebenfalls abhängig von der Korngrösse der Badschüttung, d.h. es muss somit beispielsweise soviel Luft eingeblasen werden, bis sich die über der Fritte aufliegenden Feststoffpartikeln gleichmässig anheben und von dem Gas über die ganze Fläche homogen durchströmt werden. Die Badtiefe wiederum ist noch abhängig von der Menge der eingefüllten Feststoffpartikeln und sollte mindestens

so eingestellt werden, dass die Prozesshorde mit den Halbleiterscheiben vollständig eintaucht.

Die Verweilzeit wird im speziellen Fall so bemessen, dass die Stapelfehlerkonzentration so dicht ist und die Oberfläche der Scheibe soweit abdeckt, dass sie auf jedes Volumenelement der durchschnittlich meist 200 bis 400 μm dicken Scheiben einen punktfehlerabsaugenden Effekt ausübt. Bei einer etwa 400 μm dicken Siliciumscheibe ist hierfür beispielsweise eine Stapelfehlerdichte von etwa $10^4$ pro cm² ausreichend. Die Stapelfehler lassen sich nach der Oxydation der Scheiben durch Secco-Ätzen (2 Volumenteile 40gewichtsprozentiger, wässriger Flusssäure und 1 Volumenteil 0,15 molarer, wässriger Kaliumbichromatlösung) sichtbar machen und unter dem Mikroskop auszählen.

Durch das Einblasen des Gases, also beispielsweise Stickstoff, Argon oder insbesondere Luft, wird die «Dichte» der Feststoffschüttung als Aluminiumoxid, Siliciumcarbid oder beispielsweise Quarzkörnern soweit verringert, dass sich die Halbleiterscheiben, beispielsweise Siliciumscheiben, bequem eintauchen lassen. Die Fritte 2 sorgt dabei für eine homogene Gasverteilung, so dass die dichte Packung der Körner stark aufgelockert wird, die einzelnen Körner auf und in dem Gaspolster zu schweben beginnen und ein flüssigkeitsähnlicher Zustand entsteht. Die aufgewirbelten Körner werden durch den Gasstrom ständig an der Oberfläche der in der Prozesshorde 5 aufgereihten Halbleiterscheiben entlang bewegt und erzeugen somit eine grosse Anzahl feinster Kratzer im Bereich von deutlich unter 1 μm, in der Regel etwa um 0,1 μm, durch die bei anschliessender Oxydation bei der Fertigung von Bauelementen, Stapelfehler induziert werden, die eine ausserordentlich stark getternde Wirkung auf Punktdefekte aller Art aufweisen.

Die Scheiben werden, nachdem sie aus dem Bad genommen sind, von anhaftenden Körnern befreit, beispielsweise durch kurzzeitiges Einbringen in ein Ultraschallbad, anschliessend feucht gereinigt, beispielsweise im Falle von Siliciumscheiben durch Eintauchen in etwa 10gewichtsprozentige, wässrige Flusssäure, in welcher sich die bevorzugt eingesetzten Quarzkörner, die eventuell noch an den Scheiben anhaften leicht und rückstandsfrei lösen.

Anschliessend werden die Halbleiterscheiben einseitig poliert, wobei es sich als besonders vorteilhaft erweist, dass gemäss dem erfindungsgemässen Verfahren die Scheiben allseitig oberflächlich zerstört sind, so dass ein gerichtetes Auflegen – wie bei den als zum Stand der Technik zugehörig zitierten Verfahren – nicht erforderlich ist.

Durch das Polieren werden die Mikrokratzer auf der polierten Scheibenoberfläche quantitativ entfernt. Bei den nachfolgenden Oxydationsprozessen im Temperaturbereich von etwa 900 bis 1230 °C können sich die beschriebenen Stapelfehler ausbilden und ihre hervorragend getternde Eigenschaft auf Punktdefekte entfalten. Die Stapelfehler in der Scheibenrückseite sind dabei sehr beständig und verlieren ihre Wirksamkeit auch nach zahlreichen Oxydationsschritten innerhalb der angegebenen Temperaturgranzen nicht. Die Länge der oxydationsbedingten Stapelfehler ändert sich mit der Kristallorientierung und liegt meist in der Grössenordnung von 3 bis 8 μm bei [111] orientierten Scheiben und kann bei [100] orientierten Scheiben oxydationsbedingt auch auf Werte um 30 μm anwachsen, die Gefahr eines Durchschlagens durch die 200 bis 400 μm dicken Scheiben besteht jedoch nicht. Die Halbleiterscheiben sind nach der Oxydation absolut frei von Punktfehlern oder Punktdefektagglomeraten.

Beispiel 1

In einem 120 × 180 mm grossen Blechkasten mit einer Höhe von 300 mm, wie er in Fig. 1 dargestellt ist und in welchem etwa 30 mm über dem Boden eine 5 mm dicke Quarzfritte eingepasst war, wurde Aluminiumoxidpulver mit einer Korngrösse von 300 ± 50 μm ca. 100 mm hoch aufgeschüttet und anschliessend Pressluft von ca. 5 bar durch die Filterplatte und die überstehende Feststoffschüttung geblasen. In das fluidisierte, aufgewirbelte Feststoffbad wurde anschliessend eine Prozesshorde mit 25 geläppten und geätzten Scheiben von 75 mm Durchmesser, p-leitend und [100] orientiert eingetaucht und nach 10 sec wieder aus dem Bad gezogen.

Der gleiche Versuch wurde anschliessend mit Verweilzeiten im Bad von 30 sec, 40 sec, 60 sec und 120 sec wiederholt.

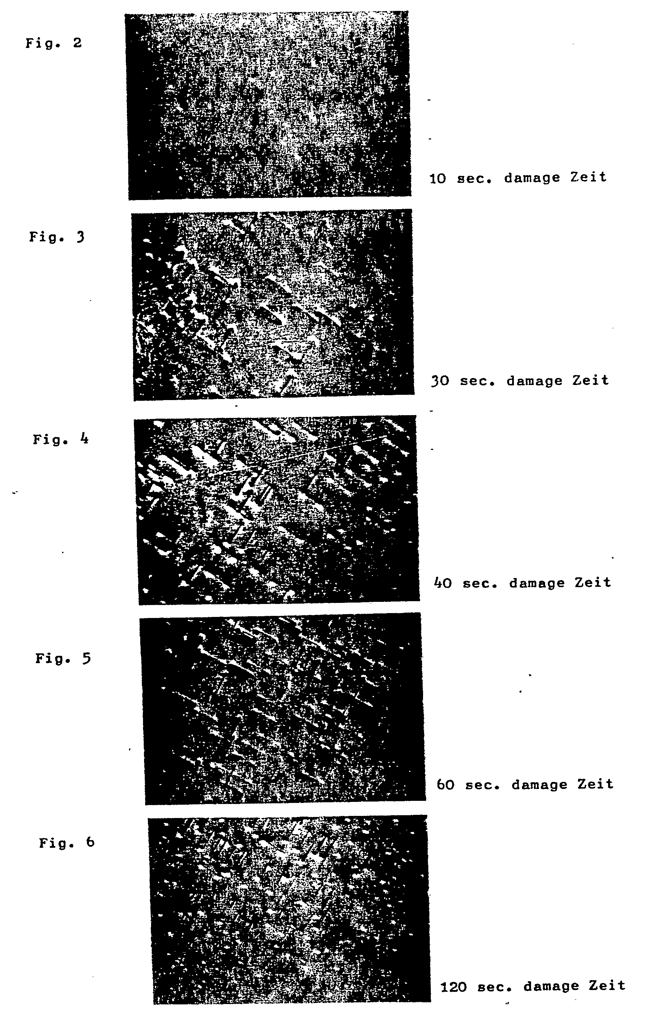

Die Siliciumscheiben wurden anschliessend jeweils ca. 120 min bei 1100 °C im Sauerstoffstrom oxydiert und Secco-geätzt. Wie aus den Fig. 2 bis 6, die die Stapelfehlerdichte in 160facher Vergrösserung zeigen, ersichtlich ist, steigt die Zahl derartiger punktfehlergetternder Stapelfehler mit der Verweilzeit im Bad bewegter Schleifkörper linear an, wobei ihre Verteilung über die Scheibenoberfläche ausserordentlich gleichmässig erfolgt.

Die erhaltenen Stapelfehler waren – wie die Fig. 2 bis 6 zeigen – unter dem Mikroskop bei 160facher Vergrösserung gut sichtbar, ihre Länge betrug etwa 25 bis 30 μm.

Beispiel 2

Es wurde eine Prozesshorde mit 25 geläppten und geätzten Siliciumscheiben mit 75 mm Durchmesser, p-leitend aber [111] orientiert 120 sec in das unter Beispiel 1 beschriebene Feststoffbad eingetaucht, wobei in diesem Fall feiner Quarzsand mit einer Korngrösse von 300 ± 50 μm als Feststoffschüttung eingesetzt wurde.

Nach dem Polieren einer Scheibenseite und ca. 2stündiger Oxydation im feuchten Sauerstoffstrom und anschliessender Secco-Ätzung wurden die Stapelfehler unter dem Mikroskop ausgezählt. Die Stapelfehlerdichte lag mit 1,5 × $10^4$ pro cm² um etwa eine Grössenordnung unter der bei [100] orientiertem p-Material bei gleicher Behandlung, ausserdem lag auch das Längenwachstum der Stapelfehler mit 8 bis 12 μm erheblich niedriger. Punktfehler wurden bei der Oxydation quantitativ durch die stapelfehlerbesetzte Scheibenrückseite abgesaugt.

### Beispiel 3

Es wurde wie in Beispiel 2 verfahren, nur mit dem Unterschied, dass die einseitig polierten Scheiben anschliessend bei 920 °C eine Stunde im trockenen Sauerstoffstrom oxydiert wurden. Auch in diesem Fall wurden sämtliche Punktdefekte und Punktdefektagglomerate quantitativ abgesaugt.

### Beispiel 4

Es wurde wie in Beispiel 2 verfahren, nur mit dem Unterschied, dass die Verweilzeit im Bad auf 150 sec erhöht und bei der Oxydation dem Sauerstoff etwa 1 Vol-% Chlor zugemischt wurde. Die Länge der Stapelfehler war offensichtlich durch die Chlorbeimengung auf 4 bis 6 μm reduziert, jedoch wurden auch hier Punktdefekte absolut vollständig abgesaugt.

### Beispiel 5

Es wurde wiederum wie in Beispiel 2 verfahren, doch wurden die einseitig polierten Scheiben nachfolgend 6 Oxydationsläufen unterworfen, wobei nach jedem Oxydationsschritt das entstandene Oxid weggeätzt und die Scheibe gereinigt wurde.

Die Absaugwirkung auf den «haze», d.h. auf die Punktdefektagglomerate blieb über alle Prozess-schritte erhalten.

### Patentanspruch

Verfahren zur Herstellung von Halbleiterscheiben mit einer Oberfläche, in der sich bei nachfolgender Oxidationsbehandlung Stapelfehler mit Punktfehler getternder Wirkung ausbilden, dadurch gekennzeichnet, dass
a) zunächst die Halbleiterscheiben einer allseitigen oberflächlichen mechanischen Beanspruchung durch Eintauchen in ein Fluidbad, bestehend aus in Pressluft bewegten Schleifkörnern von 100 bis 400 μm Korngrösse, unterzogen werden,
b) anschliessend eine Scheibenoberfläche durch Polieren von der Auswirkung dieser mechanischen Beanspruchung wieder befreit wird.

### Claim

Process for the manufacture of semiconductor wafers having a surface in which stacking faults having a gettering effect on point defects are formed during subsequent oxidation treatment, characterised in that
a) the semiconductor wafers are first subjected to surface mechanical stress on all sides by being immersed in a fluid bath comprising abrasive grains, having a grain size of from 100 to 400 μm, which are agitated im compressed air, and
b) a surface of the wafers is then freed from the effect of this mechanical stress by means of lapping.

### Revendication

Procédé pour produire des lamelles semiconductrices comportant une surface dans laquelle il se forme, au cours du traitement d'oxydation qui suit, des défauts d'empilement ayant un effet de capture (getter) des défauts ponctuels, procédé caractérisé en ce que:
a) on soumet d'abord les lamelles semiconductrices à une contrainte mécanique de surface omnidirectionnelle en les trempant dans un bain fluidisé composé de particules abrasives dont la granulométrie est comprise entre 100 et 400 μm, maintenues en mouvement dans de l'air comprimé, puis
b) on supprime sur une surface des lamelles l'influence de la contrainte mécanique par une opération de polissage.

Fig. 1

Fig. 2

10 sec. damage Zeit

Fig. 3

30 sec. damage Zeit

Fig. 4

40 sec. damage Zeit

Fig. 5

60 sec. damage Zeit

Fig. 6

120 sec. damage Zeit